# EUROPEAN PATENT APPLICATION

(11) **EP 0 911 881 A2**
(43) Date of publication of application: **28.04.1999**
(21) Application number: 98308528.3
(22) Date of filing: 19.10.1998
(51) Int. Cl.: H01L 27/146

(54) **Semiconductor diode array having radiation degradation retardation means**

(30) Priority: 20.10.1997 US 954049
(71) Applicant: GENERAL ELECTRIC COMPANY, Schenectady, NY 12345 (US)
(72) Inventor: Possin, George Edward, Niskayuna, New York 12309 (US)
(74) Representative: Goode, Ian Roy

(57) **Abstract**

An array of semiconductor diodes (10) comprised of a plurality of first semiconductor regions (12) comprising semiconductor material of a first conductivity type, and a plurality of second semiconductor regions (36) comprising semiconductor material of a second conductivity type, the second conductivity type being the opposite polarity of the first conductivity type. The first semiconductor region comprises the active regions of the array and are separated from each other by at least one of the second semiconductor regions. In one embodiment, the first semiconductor region is further separated from the adjacent second semiconductor regions by a gap region g. The opposite type semiconductor material in the second semiconductor regions reduces the detrimental effects normally created by radiation damage to the semiconductor diode.

## Description

This invention relates generally to semiconductor diode arrays, and more particularly, to an arrangement of respective semiconductor material regions within each diode of the array that retards radiation degradation of the operational performance of the array.

Radiation imagers comprised of semiconductor diode arrays are commonly used to detect ionizing radiation. The semiconductor diode arrays can be arranged with scintillators to form detector diodes and are used for X-ray Computed Tomography (CT). In such use, X-ray radiation can damage the detector diodes by increasing the leakage current therefrom and reducing the light detection efficiency of the detector diode. The increased leakage current is a source of additional noise and offsets imbalances which disadvantageously drift with temperature. The reduced light detection efficiency decreases the signal-to-noise ratio, and because the amount of radiation damage may not be uniform throughout the array, produces spatial variations in the sensitivity of the detector diodes which degrades the quality of the reconstructed CT image.

It is thus desirable that a radiation imager comprised of a detector diode array have means for reducing the operational degradations caused by the effects of radiation.

It is still further desirable to provide means for semiconductor diodes that reduce the detrimental effects of radiation, while at the same time not causing increases in other detrimental parameters, such as diode leakage currents or disadvantageous increases in the capacitance of the semiconductor diodes.

In accordance with the present invention, an array of semiconductor diodes, particularly suited for use to detect ionizing radiation, is provided with means to reduce the detrimental effects caused by operational radiation damage.

The array of semiconductor diodes comprises a plurality of first semiconductor regions comprising semiconductor material having a first conductivity type, and a plurality of second semiconductor regions comprising semiconductor material having a conductivity type opposite the conductivity type of the first semiconductor regions. The first semiconductor regions serve as the active (light detecting) regions of the diode array. First and second semiconductor regions are disposed in the array such that respective ones of the second regions are disposed between respective ones of the first regions. Both first and second semiconductor regions are disposed on a semiconductor third region comprising a semiconductor material having the a conductivity type that is the same as, but at a lower dopant concentration level, as the second region semiconductor material.

An embodiment of the invention will now be described by reference to the following description in conjunction with the accompanying drawings in which like characters represent like parts throughout the drawings and in which:

Fig. 1 is a top view schematic of the semiconductor diode array of the present invention.

Fig. 2 is a cross-section between two of the diodes of the semiconductor array of Fig. 1 illustrating a prior art arrangement not having the benefits of the present invention.

Fig. 3 is a cross-section between two of the diodes of the semiconductor diode array of the present invention.

Fig. 4 illustrates the diode current from a light spot scanned across the diode regions.

Fig. 5 illustrates a diode current from the light spots scanned from outside the cut edge to the diodes.

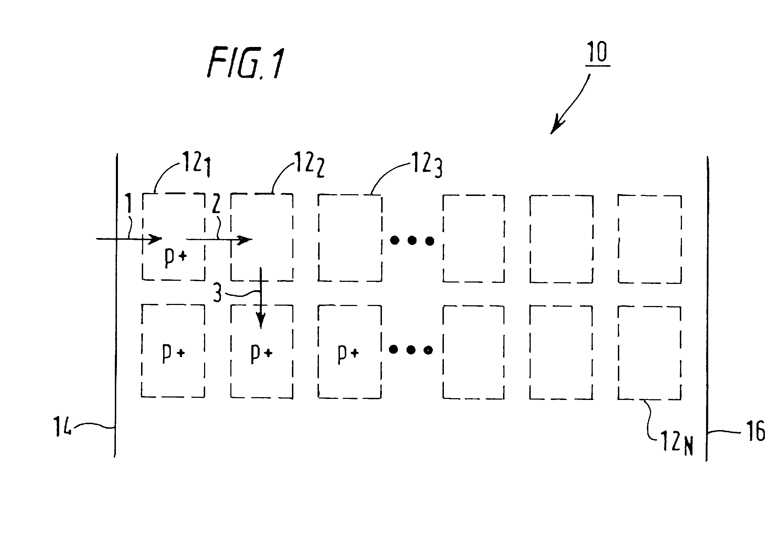

A semiconductor diode array 10 (Figure 1) in accordance with this invention is particularly suited to detect ionizing radiation, such as that which occurs during X-ray Computed Tomography (CT). Semiconductor diode array 10 comprises of individual diodes corresponding to respective first semiconductor regions shown in phantom as 12₁, 12₂, 12₃ ... 12_{N}. Each first semiconductor region 12 (also referred to as "first region") typically comprises p+doped semiconductor material, but may altematively comprise semiconductor material comprising n type conductivity. Semiconductor diode array 10 is commonly coupled to a scintillating material to make the diode array more responsive to ionizing radiation. The terms "semiconductor diode array" and "detector diode array" are used herein in an interchangeable manner.

The semiconductor diode array 10 is defined, in part, by edges 14 and 16, which edges represent the "cut edge" known in the art. The individual diodes of the array 10 collect minority carriers generated by absorption of light from the scintillator in respective first semiconductor regions. By way of illustration and not limitation, representative minority carrier paths 1, 2, 3, 4, and 5 are illustrated schematically in the figures for describing details of the diode array operation. The practice of the present invention may be better appreciated by first describing a prior art semiconductor array 1000.

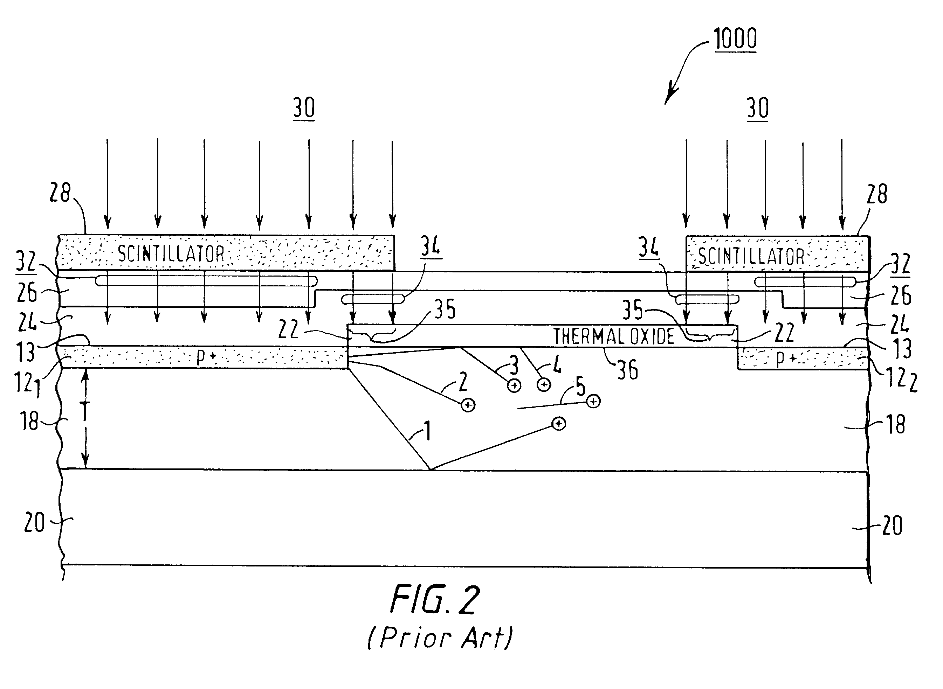

A representative portion of a conventional semiconductor array 1000 having adjacent first semiconductor regions 12₁ and 12₂ is illustrated in Figure 2. By way of illustration and not limitation, each first semiconductor region 12 illustrated in the Figures is shown as comprising p+ conductivity type semiconductor material. Although it is common in conventional diode arrays, and in diode arrays in accordance with the present invention, that the respective first regions 12₁ ... 12_{N} be of a p+ conductivity type, the respective first regions 12₁ ... 12_{N} may alternatively comprise semiconductor material of an n+ conductivity type so long as third semiconductor region 18 (also referred to as "third region") disposed around first regions 12 (except for first region light-receiving surface 13) comprises lightly doped semiconductor material of a correspondingly opposite conductivity type (e.g., p type conductivity). More particularly, the semiconductor diode array 1000 is comprised of respective first regions 12₁ ... 12_{N} and lightly doped third region 18 of semiconductor material of opposite conductivity type, with the first regions 12₁ ... 12_{N} being disposed on the semiconductor material of third region 18.

First semiconductor regions 12₁ ... 12_{N} typically are referred to as active regions and correspond with respective photosensitive diodes in the array. First regions 12 typically comprise silicon that is heavily doped (e.g., having a dopant concentration in excess of about 10¹⁸ #/cm³) (the "#" nomenclature is used to refer to the population of the particular dopant type being discussed) and commonly have a resistivity in the range between about 0.05 and about 0.0001 ohm-cm. The lightly doped third semiconductor region 18 that surrounds respective first regions 12 typically comprises silicon doped to have a resistivity of about 1000 ohms-centimeter, and has a thickness "T" of about 90 microns, but which thickness may be within a range between about 5 microns to about 500 microns. Third region 18 is disposed over a substrate 20 which preferably comprises a deep heavily doped semiconductor material layer (e.g., having a dopant concentration of about 10¹⁸ to 10²¹ #/cm³ of the same conductivity type as third region 18).

A thermal oxide protective layer 22 is disposed between respective ones of first semiconductor regions 12₁ ... 12₂ on the portion of third region 18 that is disposed between adjacent first region light-receiving surfaces 13. The thermal oxide layer preferably comprises Si0₂ and has a thickness in a range between about 0.05 microns and about 1.0 microns.

A passivation and protection layer 24 overlays the thermal oxide layer 22 and at least some of first regions 12₁ ... 12_{N}. As used herein, "overlay", "above" and the like are used for reference to relative position of items in the figures; such terms do not represent limitations on orientation of the diode array in operation. The passivation layer 24 is comprised of materials such as Si₃N₄, Si0₂, or the like, and has a typical thickness of about 1.0 microns.

An optical coupling layer 26 typically overlies the passivation layer 24. The layer 26 is formed of an optically transparent adhesive or bonding material having a thickness of about 5 microns.

A scintillator material layer 28 is disposed over coupling layer 26 in a manner, as shown in Fig. 2, such that first regions 12₁ ... 12_{N} are disposed beneath the scintillator material (to facilitate collection by the active region of photosensitive diodes of light generated in the scintillator). The scintillator material typically comprises (y_{y}Gd,0): Ce, CdW0₄, cesium iodide (CSI), or the like. A tradename of a common Scintillator is Hilight™. Scintillator layer 26 typically has a thickness of about 3 mm.

In operation, ionizing radiation, represented in Fig. 2 as X-ray beams 30, strikes the scintillator layer 28 and is absorbed, resulting in generation of optical photons, representative ones of which are illustrated in Figure 2 as light beams 32 and 34. Light beams 32 are incident on respective first semiconductor regions 12 underlying the scintillator where the x-ray was absorbed, e.g., first regions 12₁ and 12₂. Light beams 34 are incident on respective overlap regions 35, that is portions of third semiconductor region 18 that are disposed between respective first region light receiving surfaces 13. The optical photons in this overlap region typically are incident on thermal oxide protective layer 22 disposed beneath the scintillator layer 28, as shown in Fig. 2.

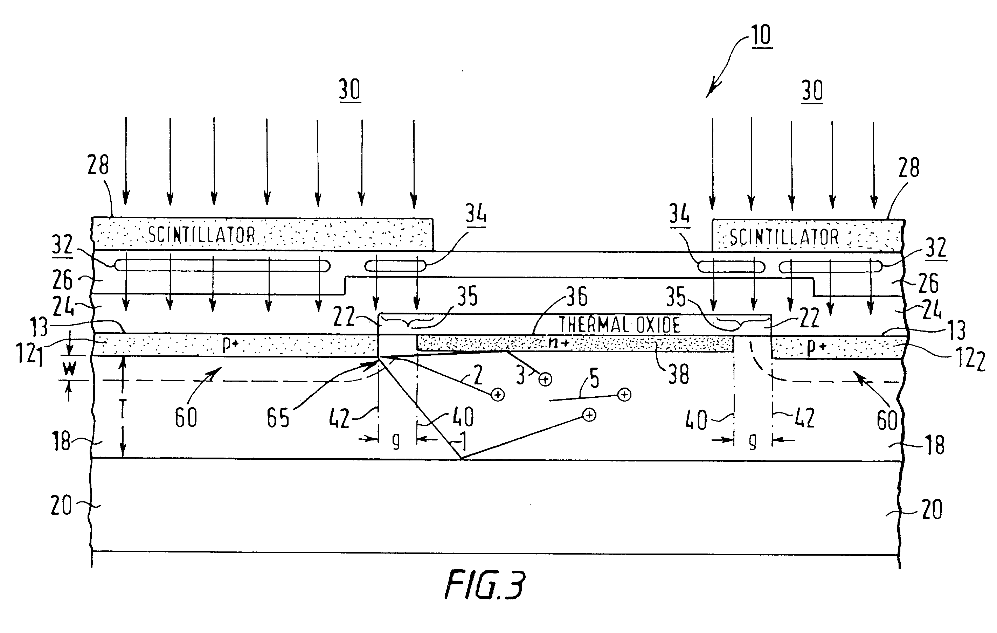

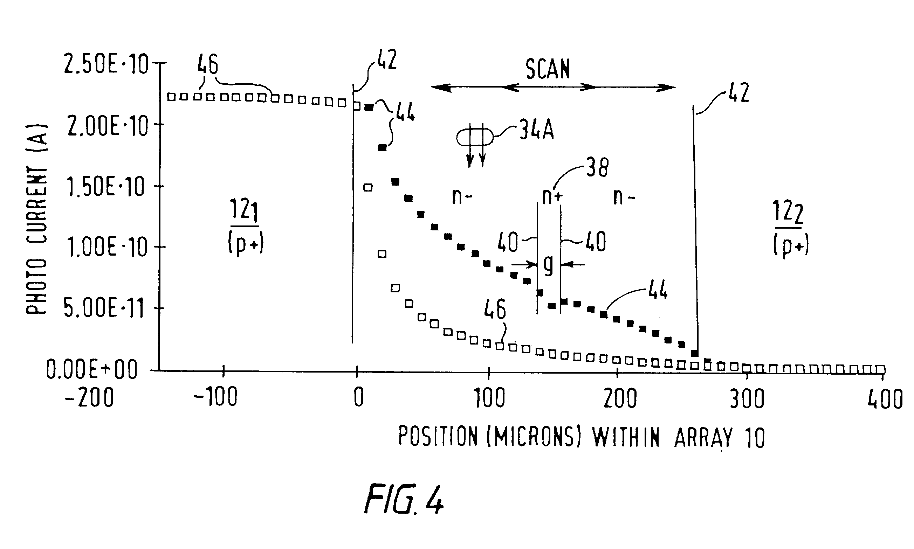

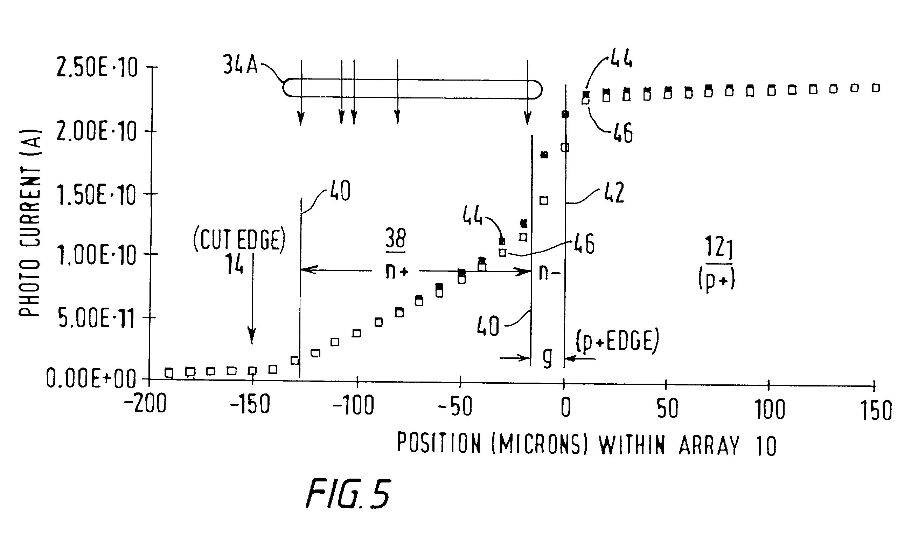

Fig. 2 (and also Fig. 3, which respects the diode array in accordance with the present invention) illustrate the starting points (the circled + sign) of illustrative minority carrier paths 1, 2, 3, 4 and 5. For purposes of clarity of illustration, these paths are shown under the thermal oxide protective layer 22; in actuality, all of the paths 1, 2, 3, 4 and 5 originate under overlap region 35 where light beam 34 is incident on protective layer 22 or under region 13. The paths 1 through 5 are drawn in Figs. 2 and 3 in order to more clearly describe the results of experiments to be further described with reference to Figs. 4 and 5.

Minority carriers generated in lightly doped third semiconductor region 18 by the absorption of light beam 34 are advantageously collected in an adjacent p+ first semiconductor region 12 that is closest to the point where light beam 34 is absorbed. Some of the minority carriers created by light beam 34, however, recombine with bulk traps (path 5 of Fig. 2) or at the surface of third region 18 (that is the portion of the surface disposed between respective first region light-receiving surfaces 13) (path 4 of Fig. 2). As semiconductor array 1000 is exposed to ionizing radiation over time, radiation damage is created which increases the density of the surface recombination sites, herein interchangeably referred to as interface states, in the vicinity of undersurface 36 of the thermal oxide protective layer 22 (that is the portion of layer 22 disposed over third semiconductor region 18). Radiation damage typically begins to be observed at radiation levels of the order of 10k Rads (Si) which corresponds to about 1 year of actual operation of the detector. This increase in the number of recombination sites increases the number of minority carriers undesirably lost in a path 4 event. This damage reduces the light-induced signal from the diode, that is, the electrical signal produced by charge collection in first semiconductor regions 12₁ ... 12_{N} and third semiconductor region 18 of semiconductor array 1000. In addition, the interface states act as generation centers and the increased density of these interface states disadvantageously increases the dark current producing a decrease in the shunt resistance of the diodes in semiconductor array 1000. In addition, the increased dark current increases the temperature instability of the dark portions of the reference signal, causing errors in the CT image.

The radiation damage undesirably increases leakage current and decreases shunt resistance, wherein shunt resistance is defined as V/I leakage, where "V" is a small voltage applied to the diode and "I" is the leakage current. Shunt resistance is defined even in the limit of V=0, where there is technically no leakage current. In a typical application, shunt resistance affects the noise of the readout circuit associated with the diode array, even if V=0. However, because readout amplifiers are not perfect, V is non-zero and so there is some leakage current that is a source of a false or offset signal, which signal varies with temperature so as to produce errors in the reconstructed CT image.

The first effect (reduced signal) reduces the light detection efficiency and the second effect (reduced shunt resistance) increases the noise (thus decreasing the signal-to-noise ratio) and increases the thermal induced drift of the offset signal. Further, because the amount of radiation damage may not be uniform, the radiation damage can produce spatial variations in the sensitivity of the semiconductor array 1000 which, in turn, degrades the reconstructed CT image. Traditional approaches to addressing this decreased efficiency suffer drawbacks, as noted below.

One way to reduce the degradation of the signal level of semiconductor array 1000 resulting from minority carriers following a path 4 event is to increase the size of the first semiconductor regions 12, such that the first regions extend beyond the lateral extents of the overlying scintillator layer 28. This increased lateral dimension of first regions 12 allows all of the light (e.g., beams 32 and 34) generated in the scintillator layer to be captured in the underlying first regions 12. Increasing the lateral extent of first regions 12 however, has undesirable effects which include: (1) reducing the spacing between respective first regions 12 in the semiconductor array, which reduction in spacing disadvantageously increases the parasitic bipolar current between respective first regions 12; this leakage current also disadvantageously decreases the shunt resistance of the diodes of the semiconductor array 1000; and (2) increasing the area of the first semiconductor regions 12 increases the capacitance of the diodes of the semiconductor array 1000; this capacitance increase, in turn, disadvantageously increases the noise in the readout circuit (that is, the circuit utilizing the semiconductor array 1000 to determine the characteristics of the ionizing radiation impinging on the semiconductor array 1000) and, thus, disadvantageously decreases the signal-to-noise ratio. The present invention reduces the degradation of the signal level caused by radiation effects without suffering the drawbacks of the prior art and may be further described with reference to Fig. 3 which is a cross sectional view primarily illustrating the portion of the array between respective first regions 12₁ and 12₂.

In accordance with the present invention, semiconductor diode array 10 (Fig. 3) further comprises a plurality of second semiconductor regions (also referred to as blocking regions) 38 disposed between adjacent first semiconductor region light receiving surfaces 13 and over portions of third semiconductor region. Diode array 10 of the present invention is otherwise similar to the semiconductor diode array 1000 of Fig. 2. Blocking regions 38 each comprise a material that is moderately heavily doped or heavily doped with a dopant of a conductivity type which is opposite of that of the first semiconductor regions 12. As used herein, "moderately heavily doped" refers to doping levels between about 10¹⁶ #/cm³ and about 10¹⁸ #/cm³. For example, if the first regions 12 comprise a p+ conductivity type semiconductor material, then blocking region 38 comprises an n+ conductivity type material; conversely, if first regions 12 comprise an n+ conductivity type material, then the blocking regions 38 would comprise p+ conductivity type material. Blocking regions 38, when doped to exhibit n+ type conductivity, produce respective electric fields that prevent positive minority carriers from reaching the undersurface 36 of thermal oxide protective layer 22. More particularly, blocking region 38 repels the minority carriers from following event path 4 (discussed with reference to Fig. 2) so as to direct the minority carriers preferentially along desired paths 1, 2, and 3 (Figs. 2 and 3). Blocking region 38 thus serves to reduce recombination of minority carriers at undersurface 36 of protective layer 22.

Array 10 of Fig. 3 is comprised of semiconductor diodes having first semiconductor regions 12 of a first conductivity type serving as active regions; disposed between respective first regions 12 are respective second semiconductor regions 38 (also referred to as blocking regions 38), each of which comprise semiconductor material of the opposite conductivity type to that of first regions 12. First regions 12 and second regions 38 are both disposed on third region 18 so as to form at least part of the surface on which thermal oxide layer 22 and passivation layer 24 are disposed. Third semiconductor region 18 comprises a semiconductor material having the same conductivity type as that of the second region 38, but more lightly doped than region 38.

In accordance with the present invention, first semiconductor regions 12 typically comprise a semiconductor material exhibiting p+ type conductivity, and second (blocking) region 38 typically comprises semiconductor material exhibiting n+ type conductivity. One benefit of the use of blocking layer 38 is to prevent depletion (or inversion) at the thermal oxide protective layer interface 36. Depletion dramatically increases the leakage current generated by the interface states (recombination sites), as more fully described in the technical article "Surface Effects of P-N Junctions-Characteristics of Surface Space-Charged Regions under Non-Equilibrium Conditions" of A. S. Grove and D. J. Fitzgerald, published in Solid-State Electronics, Vol 9, pp. 783-806 (1966).

In the practice of the present invention, respective first semiconductor regions 12 are differentiated from the opposite type of semiconductor material in second region (blocking layer 38), by a gap distance "g", illustrated in Fig. 3 as being defined by dimensional lines 40 and 42. "Differentiated" and the like as used herein with respect to the gap region refer to identification of adjacent regions (whether physically separated, adjoin one another, or overlay one another). The gap refers to the lateral dimension between the edge of one p+ regions (e.g., 12₁ or 12₂) and the edge of the n+ material in the adjacent blocking layer 38. Although the gap, "g", is shown in Fig. 3 as substantially corresponding to the scintillator overlap region related to light beam 34, in some embodiments respective scintillator overlap regions 35 are typically larger than the gap, "g". The gap, "g", typically has a lateral dimension between about 0 (e.g., the second region n+ material abuts the edge of first region P+ material) to about 15 microns, and commonly the lateral dimension of gap, "g", is in the range between about 0 to about 10 microns. The gap "g" can also be deemed to be negative, as described below.

If the gap, "g", is zero or negative, there will tend to be some increase (relative to a non-zero or non-negative gap, g) in the leakage current. The increase in leakage current is due to the typically higher defect level and higher electric field in the blocking region 38 when the region 38 is a heavily or moderately heavily doped n+ conductivity type. A negative gap means that adjacent regions 38 and 12 overlap, producing an overlap region having a doping type determined by the more heavily doped region. For example if the doping level of second semiconductor region 38 is 10¹⁸ #/cm³ (n type) and an adjacent region 12 is 10¹⁹#/cm³ (p type), the overlap region will have a conductivity defined by the mixture of the two dopants. In this example, the mixture of the two doped regions will result in a predominantly p type of doping (e.g., 10¹⁹ #/cm³ p type - 10¹⁸ #/cm³ n type = 0.9 x 10¹⁹ #/cm³ p type). Hence the overlap region (e.g. negative gap) will still have essentially the same doping and the same conductivity type at first region 12. The reason for the negative gap is to ensure (due to fabrication process tolerance) that there is no space between adjacent first and second semiconductor regions.

A zero or negative gap has an undesirable effect on the capacitance of the diode. The high doping level of second region 38 significantly reduces the width "w" of a depletion layer 60 near an edge portion 15 of the diode (e.g., corresponding to the dimensional line 42), thus increasing the capacitance of the diode. The diode capacitance is proportional to the inverse of the depletion layer 60 width; the depletion layer width "w" is proportional to the square root of the doping level of the material adjacent to first semiconductor region 12 (e.g., the doping level in either second region 38 or third region 18, whichever is immediately adjacent to first region 18). The total capacitance is the sum of the capacitance of the region under first semiconductor region 12 and the capacitance of the edge portion 65 of region 12. For example, if the doping third semiconductor region 18 underlying first region 12 is 5 x 10¹² #/cm³ the specific capacitance is about 1000 pf/cm². If the doping of second semiconductor region 38 adjacent to first region 12 (with zero gap) is 10¹⁷ #/cm³ the specific capacitance is about 10⁵ pf/cm². The effective area of the edge portion 65 corresponds to the thickness of first region 12 times its perimeter.

By way of example and not limitation using the valves for the zero gap case above, for a typical diode of size 2x2 mm the perimeter is about 8mm and the thickness is about 1 micron; thus, the effective area of edge portion 65 is about 8 x 10⁻⁵ cm² and the capacitance of this part of the structure is about 8 x 10⁻⁵ x 10⁵ = 8 pf. The capacitance of the area under first region 12 can be determined by multiplying the underside area of the diode (4mm²) by 1000 pf/cm², which thus provides about 40 pf of diode capacitance. The total capacitance of the diode in accordance with this invention would be increased from 40 pf to 48 pf in this example due to the presence of a second semiconductor region 38. Careful optimization of the doping level of second semiconductor region 38 for negative or small gaps is necessary to avoid increasing the electrical capacitance of the diode. The increased capacitance increases the noise of the readout amplifier serving the diodes. Careful optimization of the doping level for zero or small gaps (that is, less than the depletion layer thickness "w") is necessary for effective array operation. A zero or negative gap, however, still offers benefits because that arrangement provides the strongest preventive effect on any change in both diode leakage and light sensitivity due to radiation damage.

With a relatively small gap "g", such as 10 microns, an increase in interface states (recombination centers) in the gap region defined by dimensional lines 40 and 42 will have only a modest effect on the light collection efficiency. This effect is because the probability of carrier recombination in this small gap region is much less than the probability of collection by the nearby first semiconductor region 12. The radiation damage induced leakage current is more difficult to suppress because it is generated primarily in the depletion region in the vicinity of the oxide-silicon interface where the p+ material of first regions 12 is closest to the oxide of protective layer 22. These depletion regions have an extent of about 10 microns for a typical substrate doping level of 500 ohm-centimeter resistivity. Hence a gap that is greater than 10 microns will have only a small impact on the leakage before or after the radiation damage which is of concern in the present invention. Hence, when the increase in leakage current is of concern it is desirable that the gap be dimensioned to be less than 10 microns and as small as zero or negative.

When gaps much less than 10 microns (e.g., less than about 5 microns), or negative gaps, are utilized in an array to mitigate the problem of increased leakage current primarily associated with the depletion region, careful adjustment of the dopant level of the n+ material in second semiconductor region 38 is beneficial. In accordance with the present invention, calculations were performed that indicated that a dopant level in second semiconductor region 38 in the range between about 10¹⁵ and about 10¹⁸ dopants/cm³ is desired.

In the practice of the present invention tests were performed, the results of which are illustrated in Figs. 4 and 5. Both Figs. 4 and 5 have X and Y axes respectively indicating the position, given in microns, within the array 10, and the photo current (given in amperes) developed by selected individual diodes of array 10. Fig. 4 graphically presents the boundaries (lines 40 and 42) of first regions (p+) 12₁ and 12₂, and a blocking region 38 disposed therebetween that has a conductivity type opposite to that of the first regions 12₁ and 122. Fig. 5 illustrates a similar structure near the cut edge of an array such as the region of path 1 in Fig. 1. To investigate the collection of carriers generated by absorption of light 34 from scintillator 28, as shown in Fig. 2, a small focused light beam 34A, illustrated in Figure 4 in one representation position along the x-axis of about 5 microns in diameter was scanned across the surface of the detector (without a scintillator covering its surface) and the photo current was measured as a function of the position x of the beam 34A. For Fig. 4 this scanning corresponds to scanning the beam in the direction of the arrow (path) 2 or 3 in Fig. 2 and for Fig. 5 the arrow (path) 1 of Fig. 2. Further, Figs. 4 and 5 illustrate two plots 44 and 46, respectively, indicated by closed rectangular boxes and open rectangular boxes, and which are respectively representative of the current flow from diodes that have not been damaged by radiation exposure and diodes that have been damaged by a radiation exposure to 50k Rads.

Fig. 4 illustrates the current response of one diode, such as first region 12₁ in Fig. 1, as the light spot beam 34A is scanned between two diodes along the path 2 in Fig. 1. Current from all other diodes, and in particular diode 12₁, is collected by other amplifiers (not shown) or a ground connection (also not shown) and not detected by the current amplifier used to monitor the photo current indicated Fig. 4. In the Fig. 4 structure, the n+ second semiconductor region 38 is very small and the gap is large, about 125 microns. The gap is so large that this case is essentially related to the most commonly used prior art structure shown in Fig. 2. In the prior art it is common to provide a small n+ region to improve the quality of the electrical contact to substrate. From Fig. 4 it should be noted that there is a large drop in photo current when the light beam is in the gap region between x = 0 and 250 microns. The region between 0 and 50 microns is particularly important to the present invention because this region is the same as that shown in Fig. 2 where light (beam 34) from the scintillator 28 impinges on the detector outside of the diode regions (12₁ and 12₂).

Fig. 5 shows the case where the gap, "g", is about 20 microns. For such a gap dimension, the same radiation damage (50k Rads) as that of Fig. 4 produces a much smaller reduction in the light response. More particularly, a comparison between Figs. 4 and 5 reveals that the gap dimension represented in Fig. 5 of about 20 microns provides a much smaller reduction (difference between plots 44 and 46 (radiation damage 50k Rads)) relative to the reduction illustrated in Fig. 4 (which is representative of a gap of about 125 microns). These preliminary experimental results, shown in Figs. 4 and 5, confirm calculations that a gap dimension of less than 10 microns was desired for maximum reduction in the radiation damage effect on light response. Subsequent devices fabricated with 10 micron gaps exhibited no detectable reduction in light response for 50k Rad radiation exposure. With the gap dimension reduced to 10 microns, the reduction in shunt resistance was only 15%, compared to 50% for either the case with no gap or a much larger gap dimension relative to the 10 micron gap arrangement discussed above.

It should now be appreciated that the practice of the present invention provides for means for reducing the detrimental operational effects created by radiation damage.

It should be further appreciated that the practice of the present invention provides means to correct for the operational radiation degradation for a semiconductor diode array cooperating with a scintillator which are both preferably used in radiation imagers that are responsive to ionizing radiation.

## Claims

1. A radiation-damage resistant array (10) of semiconductor diodes comprised of a plurality of first semiconductor regions (12), each of said first semiconductor regions comprising a first conductivity type semiconductor material and serving as an active region for said diode array, said array further comprising a plurality of second semiconductor regions (36), each of said second semiconductor regions comprising semiconductor material having a conductivity type opposite said first conductivity type of said first semiconductor regions;
respective ones of said second semiconductor regions being disposed between respective ones of said first semiconductor regions, both of said pluralities of regions further being disposed on a third region (18)comprising semiconductor material having a conductivity type that is the same as said second region but having a lower dopant concentration than said second region.

2. The array of semiconductor diodes (10) according to claim 1, wherein said first semiconductor region is differentiated from said second region by a gap region g therebetween.

3. The array of semiconductor diodes (10) according to claim 2 further comprising a protective layer thermal oxide material (22) disposed over said second semiconductor regions and over at least a portion of said gap region g disposed between said first and second regions of adjacent diodes of said array.

4. The array of semiconductor diodes (10) according to claim 3 further comprising a passivation layer (24) disposed over said protective layer and over said first semiconductor regions of said diodes.

5. The array of semiconductor diodes (10) according to claim 4 further comprising a layer of scintillator material (28) disposed over said first regions and portions of said gap regions.

6. The array of semiconductor diodes (10) according to claim 2, wherein said gap region g has a lateral dimension in the range between about 0 to about 15 microns.

7. The array of semiconductor diodes (10) according to claim 2, wherein said gap region g has a lateral dimension in the range between about 2 to 15 microns and said second semiconductor region has a doping level in the range between about 10¹⁶ to about 10¹⁹ dopants per cm³.

8. The array of semiconductor diodes (10) according to claim 2, wherein said gap region g has a lateral dimension that is less than about 5 microns and said second region (36) has a doping level in the range between about 10¹⁶ to 10¹⁹ dopants per cm³.

9. The array of semiconductor diodes according to claim 1, wherein said third region semiconductor material is disposed over a heavily doped semiconductor material substrate of the same conductivity type as said third region.

10. The array of semiconductor diodes according to claim 1, wherein said third region semiconductor material has a thickness of between about 10 microns to about 150 microns.

11. The array of semiconductor diodes (10) according to claim 1, wherein said first region (12) comprises semiconductor material of a p+ conductivity type.

12. The array of semiconductor diodes (10) according to claim 1 1, wherein said first semiconductor region (12) has a resistivity in the range between about 0.05 and about 0.0001 ohm-cm.

13. The array of semiconductor diodes (10) of claim 2 wherein said gap g has a value denominated as one of positive, negative, or zero.
